# EUROPEAN PATENT APPLICATION

(11) **EP 0 924 762 A2**
(43) Date of publication of application: **23.06.1999**
(21) Application number: 98121303.6
(22) Date of filing: 09.11.1998
(51) Int. Cl.: H01L 23/528, H01L 21/321

(54) **Interconnections in integrated circuit devices**

(30) Priority: 22.12.1997 US 995476
(71) Applicant: SIEMENS AKTIENGESELLSCHAFT, 80333 München (DE)
(72) Inventor: Bergner, wolfgang, Stormville, NY 12582 (US); Gall, Martin, South Burlington, VT 05403 (US); Weigand, Peter, 82008 Unterhaching (DE)
(74) Representative: Patentanwälte Westphal, Mussgnug & Partner

(57) **Abstract**

For use in a damascene process for forming the conductive interconnection network of an integrated circuit device, the relatively wide trenches (21) in an insulating layer (20A, 20B) are provided with arrays of insulating plugs 22 to avoid dishing in the metallic conductive paths when chemical mechanical polishing is used to planarize the surface.

## Description

### Field of the Invention

This invention relates to integrated circuit devices, and more particularly, to the technology for providing the conductive interconnections needed in such devices.

### Background of the Invention

After the various circuit components of an integrated circuit, such as transistors, diodes and resistors, have been formed in the semiconductor chip that houses the integrated circuit, it becomes necessary to interconnect the circuit components to complete the integrated circuit. Generally this is done by providing conductors, appropriately patterned and insulated, over the surface of the semiconductive chip, which is typically silicon.

As the density of the circuit components in the chip has increased, the width and depth of the conductors forming the interconnections has decreased, so that typically these depths are measured in nanometers and the widths in fractions of microns. Additionally, to maintain the desired low resistance of the interconnections, it has become increasingly important to use conductors of high conductivity for the interconnection, such as metals. The patterning of metals, particularly to dimensions of the kind required, is difficult. For patterning the metallic conductors into interconnect networks, the damascene process has been growing in popularity. In such process, there is first deposited an insulating layer over the top surface of the silicon chip, and this layer is then patterned by standard lithographic and reactive ion etching (RIE) techniques to form trenches in the desired interconnect pattern. This is followed by a deposition of a layer of the desired metallic conductor over the surface of the insulating layer for filling the trenches that have been etched therein. This is followed by chemical mechanical polishing (CMP) of the surface to planarize the surface, leaving the metal only in the trenches. In such polishing, the insulating material acts as a stop. The conductive pattern that is formed in the trenches generally includes both lines that are relatively narrow to permit tight packing of the circuit components and lines that are relatively wide to provide low resistance paths when relatively high currents are required. Accordingly, the pattern of opening in the insulating layer that is to be filled needs to include both trenches that are relatively wide, e.g., between 10 and 100 microns, and trenches that are relatively narrow, e.g., fractions of a micron. A problem that arises when CMP is used to planarize the surface is "dishing" which is the thinning of the metallic layer where it is deposited in relatively wide trenches. Since the metal layer generally is thin, dishing can reduce significantly its conductivity.

To avoid dishing, it has become the practice to insert in the wide trenches longitudinal lines or strips of insulating material to narrow the span between insulating regions in the trench and act as stops to the CMP in the trench and so reduce the dishing. This design method, however, increases the chip area by several percent and provides an incompatibility between the layout generated for the conventional metal RIE processing and the layout for a damascene metallization processing.

In addition, the design of the pattern to be etched incorporating such lines is complex and generally involves considerable extra effort by the designer in the design. This invention provides a solution to the dishing problem whose design is considerably simpler to implement.

### Summary of the Invention

The present invention substitutes for the intermediate longitudinal lines or stripes of insulating material used to reduce the span of wide trenches a plurality of localized individual plugs, preferably staggered in a checkerboard pattern. The software implementation of this localized pattern turns out to be considerably simpler than the conventional longitudinal pattern.

From one aspect the present invention is directed to an integrated circuit device including a semiconductive chip in which there has been formed a plurality of circuit components that need to be interconnected, an interconnection network on the surface of the chip including a layer of insulating material having relatively wide and relatively narrow trenches and a layer of conductive material filling the trenches characterized in that the relatively wide trenches include localized plugs of the insulating material.

From another aspect the present invention is directed to a process of forming conductive interconnections on a top surface of a semiconductive chip housing an integrated circuit comprising the steps of: depositing over the top surface of the semiconductive chip a layer of insulating material; forming in the insulating layer a pattern of trenches corresponding essentially to a pattern of a desired interconnection, leaving a plurality of discrete plugs of the insulating layer in at least some of the trenches; covering the top surface of the semicondcutive chip with a layer of conductive material; and chemical mechanical polishing the top surface of the covered chip to the insulating layer and discrete plugs for leaving the conductive layer essentially in the trenches.

The invention will be better understood from the following more detailed description taken in conjunction with the accompanying drawing.

### Brief Description of the Drawings

FIG. 1 shows the conventional prior art filling scheme for relatively wide trenches priorly used in a damascene process for providing the interconnection network; and
FIG. 2 shows the filling scheme for relatively wide trenches in accordance with the present invention.

### Detailed Description

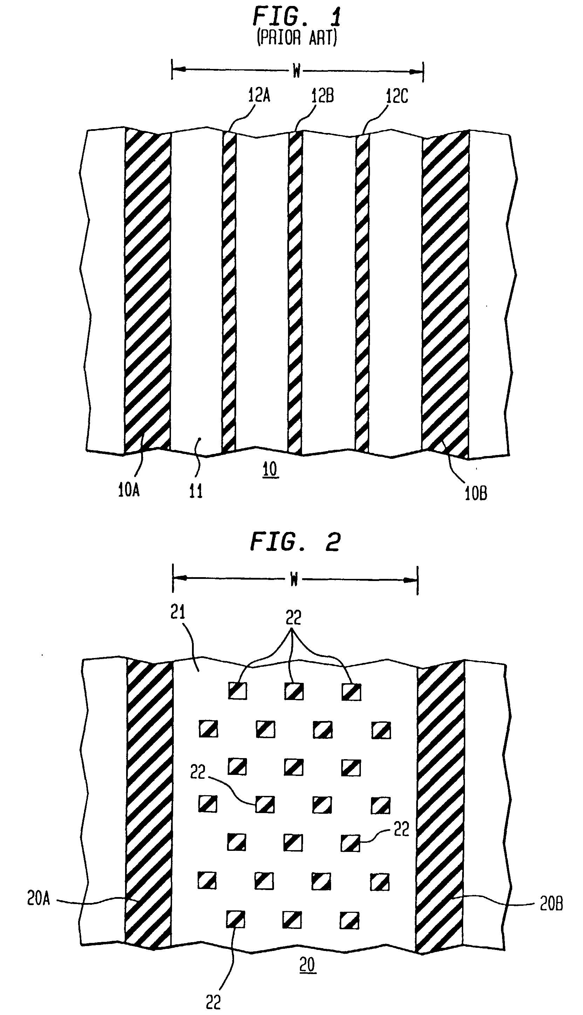

FIG. 1 is a top view of a conventional pattern of the insulating material inserted in a relatively wide trench 11 for use in interconnection network of a high density integrated circuit device 10. The full width (W) of the trench 11 is defined by the separation of side walls 10A and 10B of insulating material, which typically is between 10 and 100 microns wide. To reduce this span to avoid dishing, it has become conventional to insert the additional longitudinal lines 12A, 12B and 12C of insulating material, each typically of a width between 1 and 5 microns, depending on the width of the trench.

FIG. 2 shows a top view of a portion of an integrated circuit 20 that has a trench 21 defined between insulator side walls 20A and 20B in accordance with the present invention. Insulation plugs 22, each typically one micron square, are spaced apart between sidewalls 20A and 20B by a distance several times the width of a plug, preferably in a checkerboard pattern as shown, although other patterns may be feasible. The design of the software for the provision of such a pattern is found to be considerably simpler since the pattern can be used without change at regions of intersection of two trenches whereas the longitudinal lined pattern shown in FIG. 1 must be modified at regions of intersection of two trenches to avoid current path interruptions.

It can be appreciated that the size, shape and density of the insulating plugs 22 can vary over a wide range. Generally the insulating material used is of silicon oxide or silicate glass, although it should be apparent that the invention is not dependent on a particular choice either of the insulating material or of the conductor used to provide the interconnection. However, typically the conductive material will be chosen from the group consisting of AL, Al Cu, Al Cu Si, Cu, W, doped polysilicon and metallic silicides. Also the insulating material typically will be chosen from the group consisting of silicon oxide, silicon nitride, a silicate glass, and organic dielectrics.

Moreover the size, shape and spacing of the plugs are chosen as appropriate to a particular design. Typically the plugs will have dimensions both of width and length in fractions of a micron and will be spaced apart a distance several times their width and length dimension. These dimensions can be chosen according to the amount of dishing during the CMP processing. The increase in sheet resistance compared to a metal line produced in a conventional metal RIE process can be compensated by increasing the depth of the trenches accordingly. The compensation factor is easily obtained by (RIE metal area - area of filing pattern)/RIE metal area. This fact allows the generation of the layout according to conventional metal RIE design rules followed by the computer generation of the proposed filling pattern.

## Claims

1. An integrated circuit device including a semiconductive chip in which there has been formed a plurality of circuit components that need to be interconnected, an interconnection network on the surface of the chip including a layer of insulating material having relatively wide and relatively narrow trenches and a layer of conductive material filling the trenches characterized in that the relatively wide trenches include localized plugs of the insulating material.

2. The integrated circuit device of claim 1 in which the localized plugs of insulating material are arranged in a checkerboard pattern.

3. The integrated circuit device of claim 1 in which the plugs are of a fraction of a micron in both width and length.

4. The integrated circuit device of claim 3 in which the plugs are spaced apart from one another by at least several times each of their width and length.

5. The integrated circuit device of claim 1 in which the insulating material is chosen from a group consisting of silicon oxide, silicon nitride, silicate glasses, and organic material.

6. The integrated circuit device of claim 5 in which the conductive material is chosen from the group consisting of Al, Al Cu, Al Cu Si, Cu, W, metallic silicides, and doped polysilicon.

7. The integrated circuit device of claim 6 in which the localized plugs are arranged in a checkerboard pattern and are spaced apart from one another by a distance several times each of their width and length.

8. A process of forming conductive interconnections on a top surface of a semiconductive chip housing an integrated circuit comprising the steps of:
depositing over the top surface of the semiconductive chip a layer of insulating material;
forming in the insulating layer a pattern of trenches corresponding essentially to a pattern of a desired interconnection, leaving a plurality of discrete plugs of the insulating layer in at least some of the trenches;
covering the top surface of the semicondcutive chip with a layer of conductive material; and
polishing the top surface of the covered chip to the insulating layer and discrete plugs for leaving the conductive layer essentially in the trenches.

9. The process of claim 8 wherein the polishing step comprises chemical mechanical polishing.

10. The process of claim 9 in which the pattern of trenches includes both relatively wide and relatively narrow trenches and the discrete plugs are left only in the relatively wide trenches.

11. The process of claim 9 in which the discrete plugs are formed in a checkerboard pattern in the relatively wide trenches.

12. The process of claim 11 in which the plugs are spaced apart a distance several times their width and length dimension.

13. The process of claim 12 in which the dimensions both of width and length of the plugs are fractions of a micron.

14. The process of claim 13 in which the conducting layer is of a material chosen from the group consisting of Al, AlCu, AlCuSi, Cu, W, metallic silicides and doped polysilicon, and the insulating layer is of a material chosen from the group consisting of silicon oxide, silicon nitride, silicon glasses, and organic material.
